# EUROPEAN PATENT APPLICATION

(11) **EP 1 956 379 A1**
(43) Date of publication of application: **13.08.2008**
(21) Application number: 08250431.7
(22) Date of filing: 06.02.2008
(51) Int. Cl.: G01R 19/25

(54) **Indicia for channels collected into a group**

(30) Priority: 12.02.2007 US 889514 P; 27.11.2007 US 945810
(71) Applicant: TEKTRONIX, INC., Beaverton, OR 97077-0001 (US)
(72) Inventor: Dickinson, Evan A., 105 Portland, Oregon 97201 (US); Running, Leif X, Portland, Oregon 97212 (US); Herring, Steven C., Beaverton, Oregon 97007 (US); Tarr, Tony L., Portland, Oregon 97218 (US)
(74) Representative: Brinck, David John Borchardt

(57) **Abstract**

An indicia for channels that are collected into a group has a head situated adjacent channel numbers representing the channels included within the group, and has a tail that encompasses the channel numbers. When the last channel in the group is selected, further turning of a Select knob in the same direction results in selection of the group, which selection is indicated by highlighting at least a portion of the indicia.

## Description

### FIELD OF THE INVENTION

The present invention relates to the display of multiple data channels, and more particularly to indicia for channels that are collected into a group.

### CROSS REFERENCE TO RELATED APPLICATION

The subject patent application is a non-provisional application claiming priority from US Provisional Patent Application Ser. No. 60/889,514, entitled INDICIA FOR CHANNELS COLLECTED INTO A GROUP (Dickenson, et al.) filed 12 February 2007, and hereby incorporated by reference.

### BACKGROUND OF THE INVENTION

Many test and measurement instruments, such as logic analyzers (LAs) and mixed signal oscilloscopes (MSOs), provide for the display of multiple logic channels of data. One such example of channel grouping is described in co-pending U.S. Patent Application Serial No. [Attorney Docket No. 8321] which provides a user with complete flexibility in grouping of channels without regard to decode busses. The grouping of channels allows the channels in the group to be turned on/off together or moved on the display together. Generally the channel numbers are displayed along the left-hand side of the display adjacent the associated channels. However it is not readily apparent that the channels are part of a group or that the group is being selected as opposed to an individual channel within the group.

What is desired is an indicia for channels that are collected into a group which shows both the channels in the group as well as whether the group is selected.

### SUMMARY OF THE INVENTION

Accordingly, the present invention provides an indicia for channels that are collected in a group to indicate which channels are in the group and whether the group or a channel within the group is selected. The indicia generally includes a head and a tail, the head being situated adjacent the group and the tail encompassing channel numbers that are included within the group. Preferably the head is a triangle situated at the top of the channel numbers within the group, the triangle pointing down toward the channel numbers that belong to the group. The tail may be a bar that extends through the channel numbers from the triangle like a skewer to encompass the channel numbers within the group. When a Select knob, for example, has selected the top channel in the group, further turning of the Select knob in the same direction causes the group to be selected. Selection of the group results in the indicia being highlighted. Turning again of the Select knob in either direction then deselects the group and selects either the next channel above the group on the display or the channel at the top of the group.

The objects, advantages and other novel features of the present invention are apparent from the following detailed description when read in conjunction with the appended claims and attached drawing.

### BRIEF DESCRIPTION OF THE DRAWING

FIGURE 1 is a plan view of a display using the indicia according to the present invention.

FIGURE 2 is a partial plan view of the display of FIGURE 1 showing the indicia in greater clarity according to the present invention.

FIGURE 3 is a graphic illustrative view showing how the indicia changes to indicate group selection according to the present invention.

FIGURE 4 is a graphic illustrative view showing groupings in a vertical arrangement.

FIGURE 5 is a graphic illustrative view showing groupings in a horizontal arrangement.

### DETAILED DESCRIPTION OF THE DRAWING

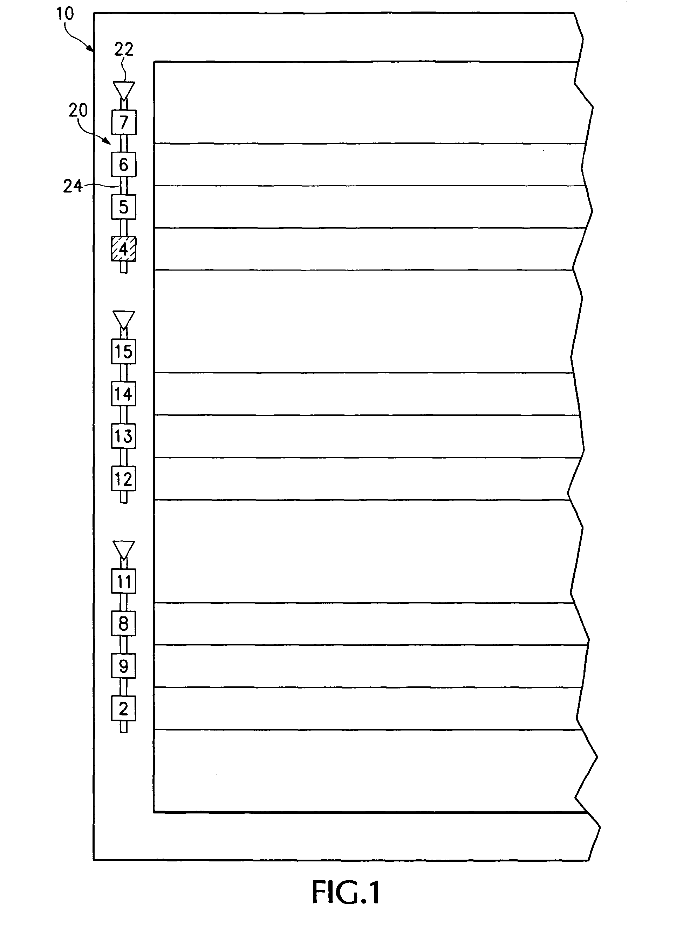

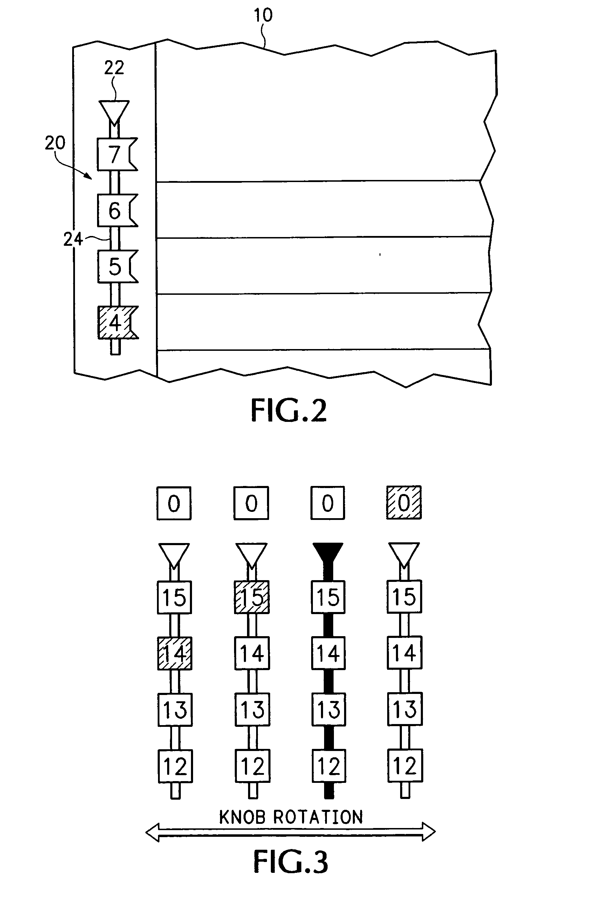

Referring now to FIGURE 1 a display **10** is shown having a plurality of channels grouped into four groups of four channels each. The channel numbers are indicated at the left of the display **10.** The groupings may be inferred by the proximity of the channels to each other, although in many cases they may not in fact be a group depending on how "proximity" is defined. However an indicia **20** also is shown at the left of the display **10** which clearly indicates which channels are grouped together no matter how much vertically separated the channels may be on the display. The indicia **20** includes a "head" **22** and a "tail" **24,** which in this example are shown as a downward pointing triangle at the top of each group and a bar running through the channel numbers that make up the group like a skewer. The head **22** and tail **24** are shown in outline form while one of the channel numbers ("4") is highlighted, indicating that currently channel 4 is selected. FIGURE 2 is a detailed view of the left hand side of the display for one of the groups shown in FIGURE 1. The channel number indicators have a "bracket" indicator at the right hand side for the height of the logic signal when it is displayed for that channel.

To use the group concept as disclosed in the aforementioned co-pending Patent Application, a user needs to understand when a group is selected as opposed to an individual channel, and needs to know what will be selected next when a knob used as a Select knob is turned. As shown in the graphic illustration of FIGURE 3 there is a group as indicated by the indicia **20** made up of channels 15-12 and an individual channel 0 above the group on the display **10.** Initially channel 14 is selected, as indicated by the highlighting of the channel number. As the Select knob is turned in one direction channel 15 is then selected, which is the top channel in the group. Another turn of the Select knob in the same direction results in the group being selected, as indicated by the indicia **20** being highlighted, such as by filling in the outline that makes up the indicia. Further turning of the Select knob results in the same direction selects the individual channel 0, while turning the Select knob in the opposite direction would reselect channel 15. In either case the group is deselected.

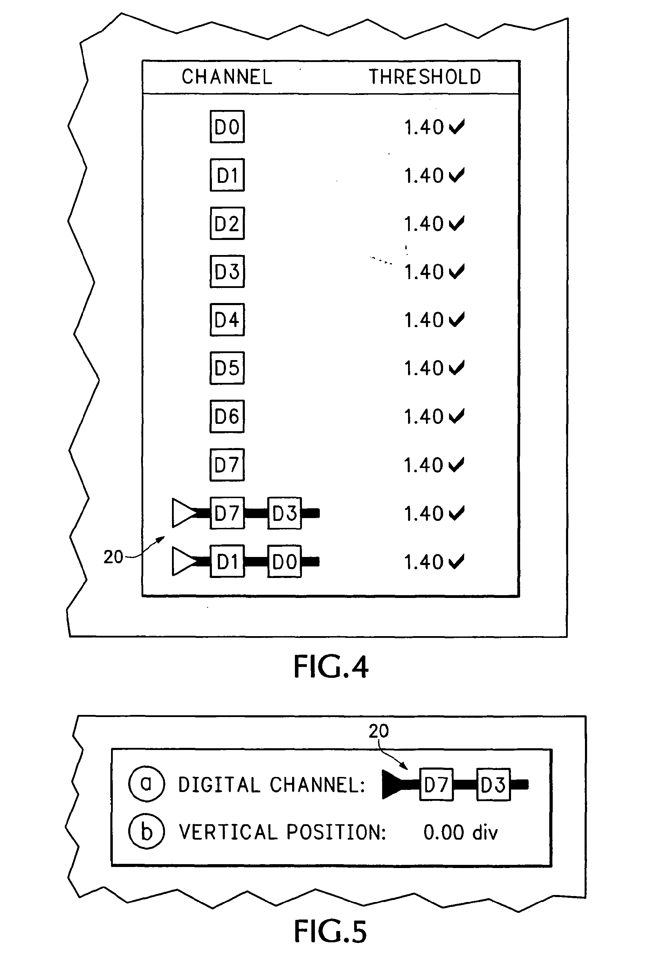

The same indicia **20** may be used in other parts of the instrument user interface (UI). For example as shown in FIGURE 4 when a group is listed on a channel menu the indicia **20** may be used in a horizontal manner, rather than vertical, to indicate that the channels D7-D3 are a group. Such a listing does not list all the channels in the group even though they may not be in sequential order, but only the channels at the beginning and end of the group. Likewise as shown in FIGURE 5 for a display of what is selected by the Select knob the horizontal configuration may be used as in the menu display when a group is selected.

Although shown as a triangle **22** and a bar **24,** the indicia **20** may take on any form, such as a circle, square, polyhedron, etc. for the head and a bracket, line, etc. for the tail, that clearly shows which channels are associated in a group and indicates whether the group is selected or not. Also the head **22** may be at either the top or bottom (left or right) of the grouped channels, and the tail may be in the form of a bracket around the channels rather than a bar running "through" the channel numbers. The significant features are an indication of which channels belong in the group and of when the group is selected. Further the head **22** may be integral with and indistinguishable from the tail **24** so long as the configuration indicates which channels are in the group, and when the group is selected.

Thus, the present invention provides an indicia for channels that are grouped together which shows both the channels which are in the group as well as when the group is selected, the indicia preferably having a head at one end of the group of channels and a tail that encompasses the channels within the group.

## Claims

1. An indicia for a group having a plurality of channels associated together comprising:
a head situated adjacent the group; and
a tail encompassing the plurality of channels, at least a portion of the indicia being highlighted when the group is selected.

2. The indicia as recited in claim 1 wherein the portion comprises the head.

3. The indicia as recited in claim 2 wherein the portion further comprises the tail.

4. The indicia as recited in claim 1 wherein the portion comprises the tail.

5. The indicia as recited in claim 1 wherein the head comprises a symbol in an outline form, the outline form being filled when the group is selected.

6. The indicia as recited in claim 5 wherein the symbol comprises one selected from the group consisting of a circle, an ellipse, a triangle, a rectangle and a polyhedron.

7. The indicia as recited in claim 1 wherein the tail comprises a bar that passes through channel numbers representing the plurality of channels.

8. The indicia as recited in claim 1 wherein the tail comprises a bracket adjacent to and encompassing channel numbers representing the plurality of channels.

9. The indicia as recited in claim 1 wherein the head comprises a triangle pointing toward the plurality of channels.

10. The indicia as recited in claim 9 wherein the tail comprises a bar extending from the triangle through channel numbers that represent the plurality of channels.

11. A test and measurement instrument operable to receive and display a plurality of data channels, the test and measurement instrument comprising:
means for displaying plurality of received data channels;
means for grouping two or more displayed channels; and
means for indicating the grouped displayed channels on the display means,
wherein said indicating means is operable to display an indicia as claimed in any preceding claim.
